# EUROPEAN PATENT APPLICATION

(11) **EP 4 632 446 A1**
(43) Date of publication of application: **15.10.2025**
(21) Application number: 24169404.1
(22) Date of filing: 10.04.2024
(51) Int. Cl.: G02B 5/08, G02B 7/00, G02B 7/182, G02B 7/198, G02B 26/08, G02B 27/64, G03F 7/00

(54) **BEAM GUIDING DEVICE FOR GUIDING LASER RADIATION AND LITHOGRAPHY SYSTEM**

(71) Applicant: TRUMPF Lasersystems for Semiconductor Manufacturing SE, 71254 Ditzingen (DE); ASML Netherlands B.V., 5504 DR Veldhoven (NL)
(72) Inventor: FRÖHLICH, Sascha, 70469 Stuttgart (DE); SCHILLING, Tom, 70435 Stuttgart (DE); FRÖHLICH, Benjamin, 70597 Stuttgart (DE); GAUDER, Patrick, 70563 Stuttgart (DE); DONE, Vamshidhar, 5658 GD Eindhoven (NL)
(74) Representative: Kutzenberger Wolff & Partner

(57) **Abstract**

The present invention concerns a beam guiding device (200) for guiding laser radiation, comprising a body (201) with an inner beam channel (202), an optical beam guiding element (205), in particular a mirror, that is arranged inside the beam channel and a bracket (203) for holding the body (201), wherein the body (201) is connected to the bracket (203) via a first flexure bearing (207), a second flexure bearing (208) and a revolute joint (209). The invention further concerns a lithography system (101), in particular extreme ultraviolet lithography system, comprising a drive laser (100) with a beam guiding device (200) as mentioned before.

## Description

The invention concerns a beam guiding device for guiding laser radiation, comprising a body with an inner beam channel and an optical beam guiding element, in particular a mirror, that is arranged inside the beam channel. The invention further concerns a lithography system, in particular an extreme ultraviolet lithography system.

The invention can be applied in the field of drive laser systems for use in extreme ultraviolet (EUV) lithography. Those drive laser systems typically include a laser source for generating pulsed laser radiation and one or more optical amplifiers for amplifying the pulsed laser radiation. Generally, the optical amplifiers include cavities that are filled with a laser gas, e.g., a mixture comprising CO₂, N₂ and He. The laser gas may be excited by radio-frequency (RF) signals applied to the laser gas using electrodes.

Optical beam guiding elements like mirrors are employed to guide the laser radiation from one cavity to the other or from the drive laser to a focussing device. Those optical beam guiding elements are typically installed within an inner beam channel of a body of a beam guiding device. The body of said beam guiding device is usually connected to a bracket that holds the body. If the body is directly connected to the bracket a rigid connection can be achieved. However, such rigid connection can be detrimental when the body and/or the bracket heat up during operation of the system. As the body and the bracket typically are made from materials with different coefficients of thermal expansion, an overdetermined connection between the body and the bracket may lead to stress and displacements that result in shifting and/or tilting of the body. Even if the same material for the body and the bracket is used, such shifting and/or tilting may occur, because the body and the bracket may be subject to different heat loads. This may change the position of the optical beam guiding element attached to the body. In prior art of optical beam guiding elements of drive lasers for EUV lithography such deformations can have a significant impact on the total laser beam drift and therefore on the total power output of the drive laser, for example due to clipping of the laser beam.

Against this background, the problem underlying the invention is to suppress the stray light induced laser beam drift in drive lasers for EUV lithography.

According to an aspect of the **invention**, a beam guiding device for guiding laser radiation is provided, comprising a body with an inner beam channel, an optical beam guiding element, in particular a mirror, that is arranged inside the beam channel and a bracket for holding the body, wherein the body is connected to the bracket via a first flexure bearing, a second flexure bearing and a revolute joint.

In the inventive beam guiding device, the revolute joint, which can also be referred to as pin joint or hinge joint, constrains the motion of the body relative to the bracket to pure rotation along an axis. This joint provides a rigid connection that is able to absorb inertial forces of the system, e.g., during transport of the system. The first and second flexure bearing, however, allow a certain movement of the body with respect to the bracket. Thereby, the flexure bearings help to avoid tensions in the event of thermally inhomogeneous expansion of the body or the bracket. As a result, tilting of the body due to thermal influence can be minimized. This increases stability of the position of the optical beam guiding element of the beam guiding device and suppresses drift of the beam of laser radiation through the beam guiding device.

The flexure bearings provided in terms of the first and second flexure bearings can alternatively be referred to as solid-state bearings.

The body may comprise, in particular consist of, a metal, e.g., aluminium. The bracket may comprise, in particular consist of, a metal, e.g., steel, in particular stainless steel.

According to a preferred embodiment of the invention, the first flexure bearing and the second flexure bearing each are configured to allow translational movement of the body relative to the bracket in a plane parallel to a connection plane between the body and the bracket. The connection plane between the body and the bracket is considered a virtual plane that is parallel to the surfaces of the body and the bracket which face each other. Thereby, undesirable movement of the body in a direction perpendicular to the connection plane can be suppressed while at the same time a certain movement parallel to the connection plane remains possible for compensating thermally induced local expansions of the material of the body and/or the bracket.

According to a preferred embodiment of the invention, the first flexure bearing is configured to allow translational movement of the body relative to the bracket only in a first direction and the second flexure bearing is configured to allow translational movement of the body relative to the bracket only in a second direction.

Preferably, the first and second directions are different, in particular are arranged at an angle. The first and second directions, however, preferably, are both parallel to the connection plane between the body and the bracket.

According to a preferred embodiment of the invention, the first direction is parallel to a virtual connecting line between the first flexure bearing and the revolute joint and the second direction is parallel to a virtual connecting line between the second flexure bearing and the revolute joint.

According to a preferred embodiment of the invention, the first flexure bearing and the second flexure bearing each comprise a first rigid section for connecting to the body and a second rigid section for connecting to the bracket, wherein the first and second sections are connected via multiple, in particular via two, three or four, flexible sections. The flexible section are preferably capable of bending. The use of multiple flexible sections within the flexure bearings allows a directed movement along with predetermined degree(s) of freedom. In particular, an embodiment having four flexible sections can be designed to allow relative, in particular translational, movement of the rigid sections along exactly one direction. The first and second rigid sections preferably include through holes for inserting a screw so as to mount the respective rigid section to either the body or the bracket. The first and/or second rigid section can additionally comprise an oblong hole for introducing a dowel pin so that the position of the flexure bearing on the bracket and/or the body can be adjusted. It is further advantageous when the four flexible sections are designed such as to allow relative rotational movement around one, two or all spatial axes.

According to a preferred embodiment of the invention, the first flexure bearing and the second flexure bearing each comprise at least one stop configured to limit relative movement of the body and the bracket in a direction parallel to a connection plane between the body and the bracket. The stops may provide overload protection, e.g., against influence of strong forces. Those force may occur during transport of the beam guiding device. Preferably, the first and second flexure bearing each comprise two stops which are arranged to limit relative movement of the body and the bracket in opposite directions. If the first flexure bearing and the second flexure bearing each comprise a first rigid section for connecting to the body and a second rigid section for connecting to the bracket, the at least one stop may be attached to or may be part of the second rigid section. Furthermore, it is advantageous if the stops are designed in such a way that, when the flexible sections abut against them, the stops always remain in a range of elastic deformation and do not exceed the threshold to plastic deformation in order to prevent unpredictable behaviour of the flexure bearings.

According to a preferred embodiment of the invention, a virtual projection of the centre of gravity of the body onto a connection plane between the body and the bracket is arranged at a position that lies within a triangle defined by the first and second flexure bearing and the revolute joint. This embodiment comes with the benefit that forces caused by masses overhanging over the area of the triangle defined by the first and second flexure bearing and the revolute joint can be reduced.

According to a preferred embodiment of the invention, the revolute joint includes a sleeve arranged between the body and the bracket. The sleeve may have the form of a hollow cylinder or may be implemented as a washer. The sleeve can help to thermally decouple, in particular to isolate, the body from the bracket. Thereby, heat transfer between the body and the bracket may be reduced and temperature induced deformations can be avoided.

According to a preferred embodiment of the invention, the revolute joint comprises a connection element, preferably a screw, wherein the sleeve is arranged concentrically with the connection element. Using the connection element, the body can be connected to the bracket such that only rotational movement of the body relative to the bracket is possible around a longitudinal axis of the connection element.

According to a preferred embodiment of the invention, the sleeve comprises a material, in particular consists of a material, having a thermal conductivity of 2 W/(m. K) or below. By using a sleeve made from material with such low thermal conductivity, the thermal decoupling of the body and the bracket can be improved. The material is preferably a ceramics material.

According to a preferred embodiment of the invention, the sleeve comprises a material, in particular consists of a material, having a Young's modulus of 200 GPa or above. By using a sleeve made from material with such high Young's modulus a connection with low elasticity can be provided.

According to another aspect of the invention, a lithography system, in particular an extreme ultraviolet lithography system, is provided, comprising a drive laser with a beam guiding device as disclosed before.

The lithography system may provide the same technical benefits and advantages as the inventive beam guiding device. Thus, reference is made to the respective description relating to the inventive beam guiding device.

Alternatively, or additionally, the advantageous embodiments and features disclosed in combination with the inventive optical amplifier can, alone or in combination, be applied to the inventive method.

Further details and advantages of the invention will be elucidated in the following using the embodiment shown in the figures.
- Fig. 1: depicts a block diagram of an embodiment of an extreme ultraviolet lithography system according to the invention;
- Fig. 2: depicts a beam guiding device according to an embodiment of the invention configured for use in the lithography system according to Fig. 1 in a side view;
- Fig. 3: depicts the beam guiding device of Fig. 2 in another side view;
- Fig. 4a: depicts an exemplary sleeve of a revolute joint configured for use in the beam guiding device according to Fig. 2 in a side view;
- Fig. 4b: depicts the sleeve of Fig. 4a in a sectional view;
- Fig. 5: depicts an exemplary flexure bearing configured for use in the beam guiding device of Fig. 2 in a schematic view;
- Fig. 6a: depicts another exemplary flexure bearing configured for use in the beam guiding device of Fig. 2 in a side view;
- Fig. 6b: depicts the flexure bearing of Fig. 6a in a sectional view.

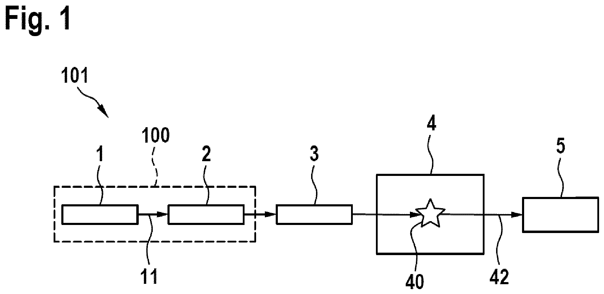

The embodiment in **Fig. 1** shows an extreme ultraviolet, EUV, lithography system 101 with a drive laser 100 that provides laser radiation to a focussing device 3, which focusses the laser radiation 11 onto a target area 40. A target material is arranged in the target area, which emits EUV radiation when irradiated with the laser radiation. According to the exemplary embodiment, the target area 40 is arranged in a target chamber 4 in which vacuum conditions prevail. The target material can be tin, for example, which is provided in drop form. The tin droplet can be heated by a pre-pulse, for example pulsed laser radiation 11 with a wavelength of 1 micron, so that the tin droplet is expanded, vaporised, ionised and/or a weak or possibly strong plasma is generated. A main pulse briefly following the pre-pulse, for example pulsed laser radiation 11 with a wavelength of 10.6 micron, can transfer the essential part of the material influenced by the pre-pulse into the plasma state, whereby the EUV radiation 42 is generated. This EUV radiation 42 is then fed to an exposure device 5 of the lithography system 10, in which the EUV radiation 42 can be used to expose semiconductor substrates.

According to the embodiment, the drive laser 100 comprises a radiation source 1 by means of which, in particular pulsed, laser radiation 11 can be generated. Even if only one radiation source 1 is shown here, two radiation sources 1 can be provided, for example to generate pre-pulses and main pulses of the laser radiation 11, which each follow one another in short succession and are focussed on a target area 40. The laser radiation generated by the radiation source 1 is amplified by an optical amplifier 2. The optical amplifier 2 includes a cavity filled with a laser active gas, e.g., comprising CO₂ and N₂ and He. The laser gas may be excited by radio-frequency (RF) signals applied to the laser gas using electrodes.

Beam guiding devices for guiding the laser radiation 11 are located at specific positions within the drive laser 100 and at the interfaces of the drive laser 100, the focussing device and/or the target chamber 4.

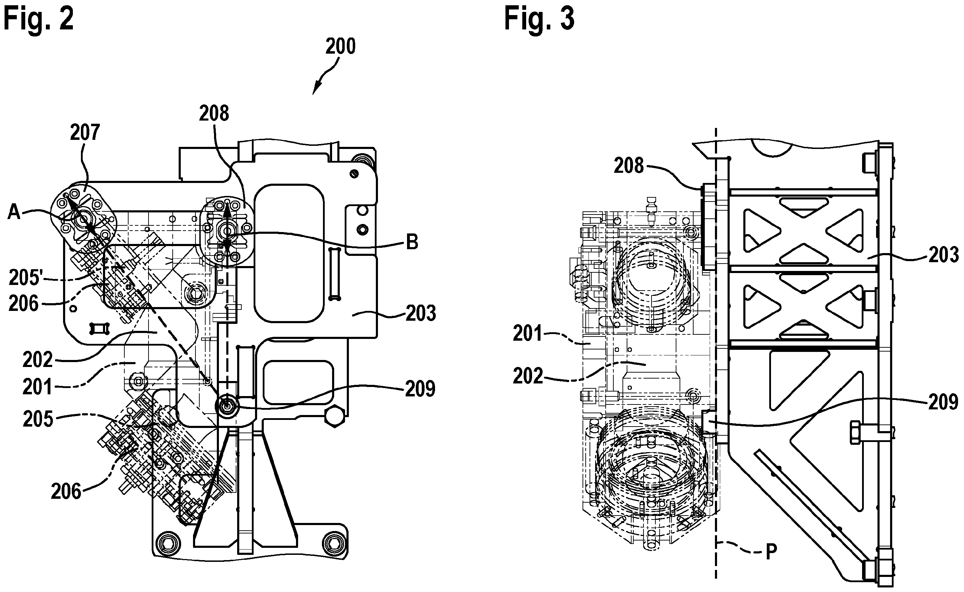

**Fig. 2** and **Fig. 3** show an exemplary beam guiding device 200 that can be employed in the lithography system 101 according to Fig. 1. For example, the shown beam guiding device 200 may be arranged at an entry opening of the optical amplifier 2, that means at the interface between the radiation source 1 and the optical amplifier 2. The beam guiding device 200 comprises a body 201, e.g., made from aluminium. For guiding the beams of laser radiation 11, the body includes an inner beam channel 202. Within the beam channel 202, an optical beam guiding element 205, here a mirror, is arranged. The optical beam guiding element 205 is attached indirectly the body 201 via a guiding element holder 206. Here, the optical beam guiding element 205 is attached to an inner surface of the beam channel 202 via the guiding element holder 206. The beam guiding device 200 according to the embodiment also includes an auxiliary beam guiding element 205', here a mirror, which is held by a respective optical beam guiding element holder 206'. The auxiliary beam guiding element 205' can be employed for purposes of metrology.

The body 201 of the beam guiding device 200 is mounted on a bracket 203 that holds the body 201. The body 201 and the bracket 203 are made from materials having different coefficients of thermal expansion, here the bracket 203 is made from steel whereas the body 201 is made from aluminium. In order to avoid to stress and displacements resulting from the difference in thermal expansion coefficients, the optical beam guiding device 200 the connection between the body 201 and the bracket 203 is designed to provide a rigid connection and at the same time allow a certain movement of the body 201 with respect to the bracket 203. In particular, the body 201 is connected to the bracket 203 via a first flexure bearing 207, a second flexure bearing 208 and a revolute joint 209. The revolute joint 209 is able to constrain the motion of the body 201 relative to the bracket 203 to pure rotation along an axis. The first and second flexure bearings 207, 208, in contrast, allow a certain movement of the body 201 with respect to the bracket 203. Thereby, the flexure bearings 207, 208 avoid tensions in the event of thermally inhomogeneous expansion of the body 201 and the bracket 203. As a result, tilting of the body 201 due to thermal influence can be minimized and beam stability is improved.

In the shown embodiment, both, first flexure bearing 207 and the second flexure bearing 208 each are configured to allow translational movement of the body 201 relative to the bracket 203 in a plane parallel to a connection plane P between the body 201 and the bracket 203. However, they constrain movement of the body 201 with relative to the bracket 203 in a direction perpendicular to the connection plane P. As visible in Fig. 3, the first flexure bearing 207 is configured to allow translational movement of the body 201 relative to the bracket 203 only in a first direction A that is oriented parallel to the connection plane P. The second flexure bearing 208 is configured to allow translational movement of the body 201 relative to the bracket 203 only in a second direction B which also is oriented parallel to the connection plane P. In other words, the first and second directions A, B are different and confine an angle. The angle is preferably in the range of 5° to 60°, more preferably in the range of 40° to 50°. Here, the first direction A is parallel to a virtual connecting line between the first flexure bearing 207 and the revolute joint 209 and the second direction B is parallel to a virtual connecting line between the second flexure bearing 208 and the revolute joint 209.

In the embodiment shown in Fig. 2 and Fig. 3, the positions of the revolute joint 209 and the flexure bearings 207, 208 have been selected so that that a virtual projection of the centre of gravity of the body 201 onto a connection plane P between the body and the bracket is arranged at a position that lies within a triangle defined by the first and second flexure bearing 207, 208 and the revolute joint 209.

The revolute joint 209 of the embodiment shown in Fig. 2 and Fig. 3 includes a sleeve 210 that is arranged between the body 201 and the bracket 203, in particular between respective connection surfaces of the body 201 and the bracket 203. A connection element, preferably a screw, is arranged concentrically with the sleeve and confines translational movement of the body 201 relative to the bracket 203 while allowing rotation about the longitudinal axis of the connection element.

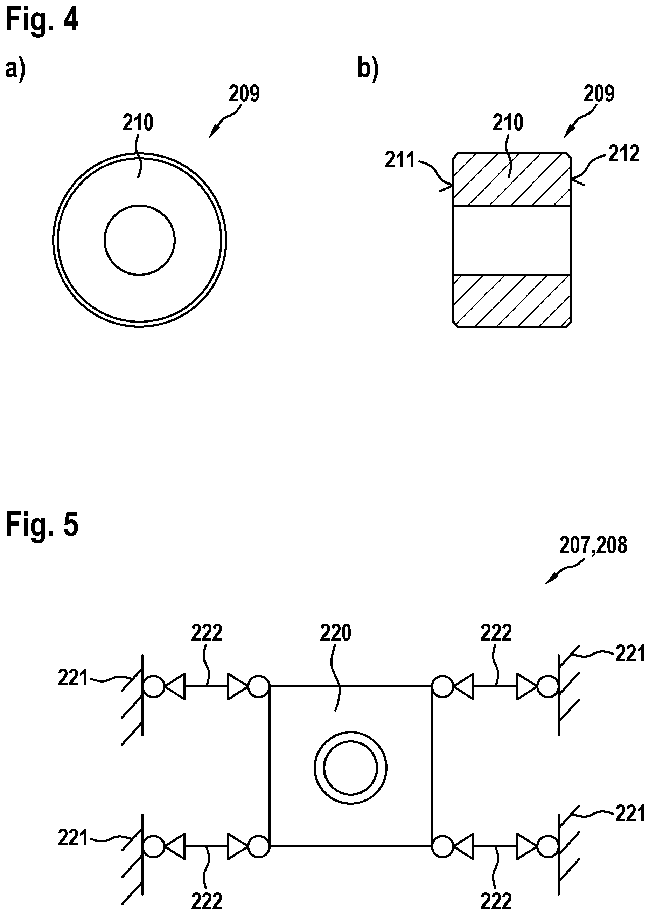

An exemplary sleeve 210 to be used in a revolute joint 209 of the beam guiding device 200 is depicted in **Fig. 4a** and **Fig. 4b****.** The sleeve 210 has an essentially hollow cylindrical form and is made from a a material having low thermal conductivity, e.g., a thermal conductivity of 2 W/(m K) or below. The material is further required to have low elasticity, e.g., a Young's modulus of 200 GPa or above. For example, ceramics materials qualify for a material of the sleeve 210.

When mounted as part of the revolute joint 209, a first end face 211 of the sleeve 210 is in contact with the body 201 and a second end face 212 of the sleeve is in contact with the bracket 212. Due to the low elasticity and the low thermal conductivity, a rigid connection with decent thermal decoupling can be provided using the sleeve 210.

In **Fig. 5** an exemplary flexure bearing 207, 208 for use in the beam guiding device of Fig. 2 and 3 is shown in a schematic representation. The flexure bearing 207, 208 includes a first rigid section 220 for connecting to the body 201, e.g., using a screw. A second rigid section 221 is provided for connecting to the bracket 203. Only for the purpose of presentation the second rigid section is divided into four separate sections in Fig. 5. However, in practice, those rigid sections 221 will be implemented as the same part. The first and second sections 220, 221 are connected via multiple, here four, flexible sections 222 which are able of being bend due to the influence of external forces.

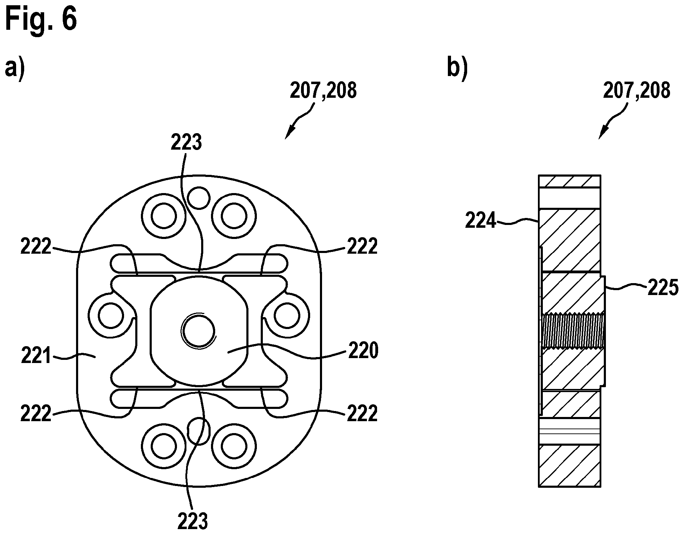

**Fig. 6a** and **Fig. 6b** depict another embodiment of a flexure bearing 207, 208 for use in the beam guiding device according to the invention. The flexure bearing 207 has a generally elongated form with rounded end faces. It is made from a metallic material, in particular steel, preferably stainless steel.

In the centre of the flexure bearing 207, 208, it comprises a first rigid section 220 which can be connected to the body 201. For this purpose, the first rigid section 220 comprises a thorough hole through which a screw can be mounted in order to fix the first rigid section 220 to the body 201. The sectional view in Fig. 6b shows that the first rigid section 220 includes a connection surface 225 that protrudes the contour of the flexure bearing 207, 208.

A second rigid section 221 is provided for connecting to the bracket 203. The second rigid section 221 includes multiple though holes for mounting screws and elongated holes for introducing dowel pins, respectively. The first and second rigid section 220, 221 are connected via four flexible sections 222. The flexible sections 222 are arranged in parallel with each other so that bending of the flexible sections 222 allows translational movement of the first rigid section 220 relative to the second rigid section 221 in only one direction, here a direction that is perpendicular to the direction the flexible sections extend in.

The flexure bearing 207, 208 as depicted in Fig. 6a and 6b includes two stops 223 configured to limit relative movement of the body 201 and the bracket 203 in a direction parallel to a connection plane P between the body 201 and the bracket 203. The stops are implemented as protrusions arranged at the second rigid section 221.

Reference Signs:
- 1: laser radiation source
- 2: optical amplifier
- 3: focussing device
- 4: target chamber
- 5: exposure device
- 11: laser radiation
- 40: target area
- 42: EUV radiation

- 101: EUV system

- 200: beam guiding device
- 201: body
- 202: beam channel
- 203: bracket
- 205, 205': optical beam guiding element, mirror
- 206, 206': guiding element holder
- 207: flexure bearing
- 208: flexure bearing
- 209: revolute joint
- 210: sleeve
- 211: surface
- 212: surface
- 220: rigid element
- 221: rigid element
- 222: flexible element
- 223: stop
- 224: surface
- 225: surface

- A, B: direction
- P: connection plane

## Claims

1. Beam guiding device (200) for guiding laser radiation, comprising a body (201) with an inner beam channel (202), an optical beam guiding element (205), in particular a mirror, that is arranged inside the beam channel and a bracket (203) for holding the body (201),
**characterized in that**
the body (201) is connected to the bracket (203) via a first flexure bearing (207), a second flexure bearing (208) and a revolute joint (209).

2. Beam guiding device (200) according to claim 1, **characterized in that** the first flexure bearing (207) and the second flexure bearing (208) each are configured to allow translational movement of the body (201) relative to the bracket (203) in a plane parallel to a connection plane (P) between the body (201) and the bracket (203).

3. Beam guiding device (200) according to any of the preceding claims, **characterized in that** the first flexure bearing (207) is configured to allow translational movement of the body (201) relative to the bracket (203) only in a first direction (A) and the second flexure bearing (208) is configured to allow translational movement of the body (201) relative to the bracket (203) only in a second direction (B).

4. Beam guiding device (200) according to claim 3, **characterized in that** the first and second directions (A, B) are different, in particular are arranged at an angle.

5. Beam guiding device (200) according to any of claims 3 or 4, **characterized in that** the first direction (A) is parallel to a virtual connecting line between the first flexure bearing (207) and the revolute joint (209) and the second direction (B) is parallel to a virtual connecting line between the second flexure bearing (208) and the revolute joint (209).

6. Beam guiding device (200) according to any of the preceding claims, **characterized in that** the first flexure bearing (207) and the second flexure bearing (208) each comprise a first rigid section (220) for connecting to the body (201) and a second rigid section (221) for connecting to the bracket (203), wherein the first and second sections (220, 221) are connected via multiple, in particular via two, three or four, flexible sections (222).

7. Beam guiding device (200) according to any of the preceding claims, **characterized in that** the that the first flexure bearing (207) and the second flexure bearing (208) each comprise at least one stop (223) configured to limit relative movement of the body (201) and the bracket (203) in a direction parallel to a connection plane (P) between the body (201) and the bracket (203).

8. Beam guiding device (200) according to any of the preceding claims, **characterized in that** the first and/or second flexure bearing (201, 208) comprise a material, in particular consist of steel, in particular stainless steel.

9. Beam guiding device (200) according to any of the preceding claims, **characterized in that** a virtual projection of the centre of gravity of the body onto a connection plane (P) between the body and the bracket is arranged at a position that lies within a triangle defined by the first and second flexure bearing (207, 208) and the revolute joint (209),

10. Beam guiding device (200) according to any of the preceding claims, **characterized in that** the revolute joint (209) includes a sleeve arranged between the body and the bracket.

11. Beam guiding device according to claim 10, **characterized in that** the revolute joint (209) comprises a connection element, preferably a screw, wherein the sleeve (210) is arranged concentrically with the connection element.

12. Beam guiding device (200) according to claim 11, **characterized in that** the sleeve (210) comprises a material, in particular consists of a material, having a thermal conductivity of 2 W/(m K) or below.

13. Beam guiding device (200) according to any of claims 10 to 12, **characterized in that** the sleeve (210) comprises a material, in particular consists of a material, having a Young's modulus of 200 GPa or above.

14. Lithography system (101), in particular extreme ultraviolet lithography system, comprising a drive laser (100) with a beam guiding device (200) according to any of the preceding claims.
